# EUROPÄISCHE PATENTANMELDUNG

(11) **EP 0 643 351 A1**
(43) Veröffentlichungstag der Anmeldung: **15.03.1995**
(21) Anmeldenummer: 93112900.1
(22) Anmeldetag: 11.08.1993
(51) Int. Cl.: G06F 11/10

(54) **Verfahren zur Erhöhung der Fehlerfreiheit von in Mikroprogrammspeichern einer Datenverarbeitungsanlage gespeicherten Mikrobefehlen und entsprechend arbeitende Mikroprogrammsteuerung**

(71) Anmelder: Siemens Nixdorf Informationssysteme Aktiengesellschaft, D-33102 Paderborn (DE)
(72) Erfinder: Olivier, Pierre, D-85521 Ottobrunn (DE); Schlimm, Georg, Dipl.-Ing., D-82024 Taufkirchen (DE)
(74) Vertreter: Fuchs, Franz-Josef, Dr.-Ing.

(57) **Zusammenfassung**

Ausgehend von einer Nachlademöglichkeit der Befehle für den Mikroprogrammspeicher (CM) erfolgt Sicherung lediglich durch Paritätsbits gekoppelt mit einer sequentiell umlaufenden Prüfung der gespeicherten Befehle im Leerlaufzustand (IDLE-CTL) der Prozessoreinheit (PROC) durch Prüfroutine (CM-TEST). Der eigentliche Lese-Prüf-Mechanismus für einen adressierten Befehl wird durch eine Subfunktion (CM-LD) ausgelöst und erfolgt hardwaregesteuert analog einem Unterprogrammsprung. Beim Nachladen eines fehlerbehafteten Befehls oder Neuladen des gesamten Mikroprogrammspeichers nach Wirksamschalten von Ersatzbausteinen wird die Hardwaresteuerung ebenfalls durch die Subfunktion (CM-LD) angesprungen und dem Lesevorgang noch ein Schreibvorgang für den bereitgestellten Befehl vorgeschaltet. Auf diese Weise können auch seltener benutzte Programmteile, insbesondere zur Fehlerbehandlung, weitgehend fehlerfrei gehalten werden, so daß sie nicht zu einem die bestehende Fehlerbeseitigungsmöglichkeit blockierenden Maschinenzustand führen.

## Beschreibung

Die Erfindung betrifft ein Verfahren zur Erhöhung der Fehlerfreiheit von in Mikroprogrammspeichern einer Datenverarbeitungsanlage gespeicherten Mikrobefehlen entsprechend dem Oberbegriff des Patentanspruches 1 und eine entsprechend arbeitende Mikroprogrammsteuerung.

In Datenverarbeitungsanlagen finden vor allem Halbleiterspeicher mit zunehmender Integrationsdichte Verwendung, wodurch die Gefahr, daß Fehler verschiedenster Art beim Betrieb auftreten, zwangsläufig vergrößert wird. Abgesehen von vielfältigen Prüfungen und Messungen vor der Produktionsfreigabe, um die günstigsten Betriebsparameter zu ermitteln, werden für den Betrieb vielfältige Maßnahmen getroffen, um die Verfügbarkeit und Fehlerfreiheit der gespeicherten Daten zu sichern. Diese Maßnahmen beziehen sich auf die Verwendung von zusätzlichen Sicherungszeichen in Form von Paritätsbits zur Fehlererkennung oder in Form von Korrekturcodes zur Fehlerkorrektur, wobei letztere einen wesentlich größeren Hardwareaufwand gegenüber der einfachen Paritätssicherung erfordern und bei direkter Einbeziehung in einen Übertragungspfad zusätzliche Laufzeiten mit entsprechender Verlängerung der Zykluszeiten bedingen.

In Verbindung mit der einfachen Paritätssicherung werden in der Regel Ersatzschaltemechanismen für die Speicher verwendet, in dem der gesamte Speicher doppelt vorgesehen wird und beide Speicher parallel betrieben werden.

Speicherausfalle lassen sich ebenfalls beheben, indem Speicherbausteine im Fehlerfall durch Ersatzbausteine ersetzt werden. Letzteres setzt aber eine Nachlademöglichkeit aus einem anderen Speicher voraus. Ist dies nicht möglich, muß zusätzlich mit einem fehlerkorrigierenden Code zur Sicherung gearbeitet werden - man siehe hierzu Electronic Design February 18, 1982, Seiten 177 bis 186; Informationstechnik it 30 (1988) 4, Seiten 247 bis 253 und IBM Technical Disclosure Bulletin, Vol. 11, No. 5, October 1968.

Um desweiteren zu verhindern, daß aus irgendeinem Grunde verursachte Fehler sich bei selten gelesenen Speichereinträgen addieren und dadurch sich trotz Sicherung durch einen Korrekturcode unkorrigierbare Daten ergeben, ist es desweiteren bekannt, jeweils im Leerlaufzustand der Datenverarbeitungsanlage die Speicherabschnitte nacheinander zu lesen und auftretende Fehler durch Wiedereinschreiben von mit einer Korrektureinrichtung korrigierten Daten zu beseitigen - US-3,735,105. Auch ist es bekannt, in einen Arbeitsspeicher neueinzuschreibende Daten unmittelbar danach wieder zu lesen und dabei auf Fehlerfreiheit zu prüfen, wobei im Fehlerfall die Daten erneut eingeschrieben werden, um das Auffinden von Fehlerursachen frühzeitig ohne größeren Aufwand erkennen zu können - EP-0 211 358-A1.

Aufgabe der Erfindung ist es einerseits, einen besonders für Mikroprogrammspeicher in Prozessoreinheiten von Datenverarbeitungsanlagen geeignetes Verfahren zur Erhöhung der Fehlerfreiheit zu schaffen, das in die Mikroprogrammsteuerung integriert ist und mit verhältnismäßig geringem Aufwand eine fortlaufende Prüfung aller im Mikrobefehlsspeicher enthaltenen Befehle auf dem normalerweise vorgegebenen funktionellen Verarbeitungsweg ohne zusätzliche Laufzeiten bedingende Korrekturmaßnahmen ermöglicht.

Diese Aufgabe wird durch die im kennzeichnenden Teil des Patentanspruches 1 enthaltene Merkmalskombination gelöst. Ausgangspunkt ist dabei eine bestehende Nachlademöglichkeit für die Befehle des Mikroprogrammspeichers aus einem anderen Speicher, so daß mit einfachen Paritätsbits gesichert werden kann, um Fehler zu erkennen. Eine zusätzliche Laufzeiten bedingende Fehlerkorrektur mit Sicherung durch zusätzlichen Aufwand bedingende Korrekturcodes im funktionellen Verarbeitungsweg entfällt dadurch. Auch wird durch die Ausführung der sequentiell umlaufenden Überprüfung aller Mikrobefehle im Mikroprogrammspeicher nur während des Leerlaufzustandes der Prozessoreinheit die Arbeitsleistung derselben kaum beeinträchtigt. Jedoch werden alle Befehle von Zeit zu Zeit überprüft. Fehler bei seltener benutzten Programmteilen können dabei früher erkannt und behoben werden und führen beim Aufruf des Programms nicht zu einem undefinierten Abbruch bzw. bei einem Fehler in einem Fehlerbehandlungsprogramm nicht zu einem die bestehende Fehlerbeseitigungsmöglichkeit blockierenden Maschinenzustand. Die mögliche Umschaltung auf Ersatzspeicher durch den Serviceprozessor ergänzt diese Maßnahme in vorteilhafter Weise und schafft dadurch weitere, die Fehlerfreiheit erhöhende Redundanz in Verbindung mit der Nachlademöglichkeit.

Weiterbildungen des Verfahrens gemäß der Erfindung ergeben sich aus den Patentansprüchen 2 bis 7, wonach insbesondere das Prüflesen von einer wie ein Unterprogramm aufrufbaren gesonderten Steuereinheit mit hardwaregesteuerten Steuerungsablauf durchgeführt wird, die abhängig von zusätzlichen Merkern unterschiedlich reagiert.

Eine für die Durchfuhrung der Verfahren geeignete Mikroprogrammsteuerung ergibt sich aus Patentanspruch 8, wozu Weiterbildungen gemäß den Patentansprüchen 9 und 10 möglich sind.

Einzelheiten der Erfindung seien nachfolgend anhand eines in der Zeichnung dargestellten Ausführungsbeispieles näher erläutert. Im einzelnen zeigen
Figur 1 das Blockschaltbild einer Datenverarbeitungsanlage mit einer gemäß der Erfindung arbeitenden Prozessoreinheit in Form eines Ein-/Ausgabeprozessors,
Figur 2 ein Übersichtsablaufdiagramm zur Erläuterung des allgemeinen Steuerungsablaufes für die Mikroprogrammsteuerung der Prozessoreinheit von Figur 1,
Figur 3 ein Ablaufdiagramm für die Prüfroutine von Figur 2,
Figur 4 ein Ablaufdiagramm für die Nachladeroutine von Figur 2,
Figur 5 ein Ablaufdiagramm für die Ersatzschalteroutine von Figur 2 und
Figur 6 ein Ablaufdiagramm für die Neuladeroutine von Figur 2.

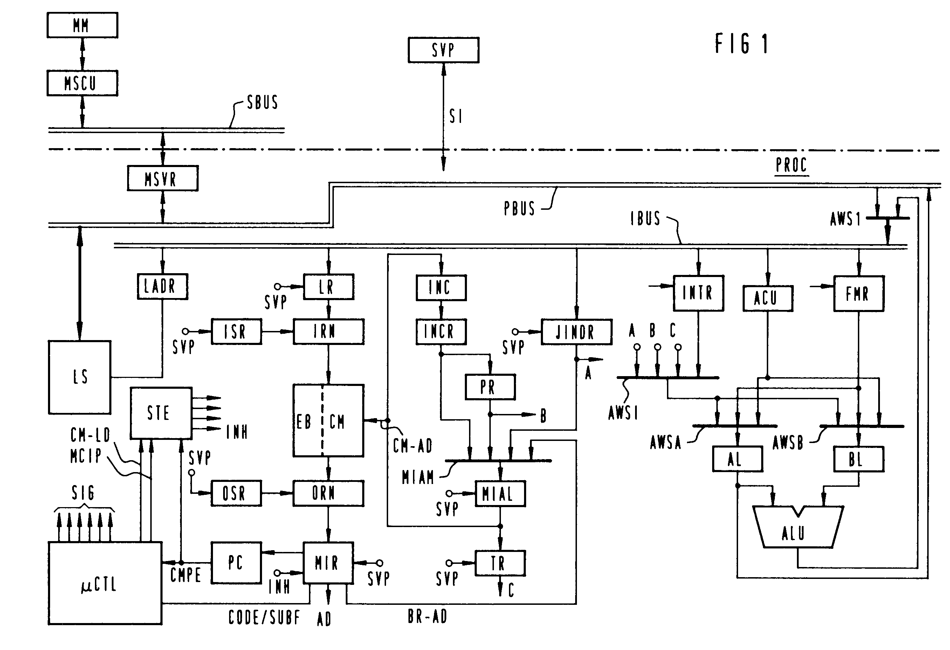

Das Blockschaltbild von Figur 1 zeigt den strukturellen Aufbau einer Datenverarbeitungsanlage mit einem Arbeitsspeicher MM und einer Speicherzugriffssteuerung MSCU, die den Zugriff der an ein Leitungssystem SBUS angeschlossenen Verarbeitungs- und Ein-/Ausgabeprozessoren zum Arbeitsspeicher MM steuert. Dargestellt ist davon nur eine Prozessoreinheit PROC, die über eine Schnittstellensteuerung MSVR mit dem Leitungssystem SBUS gekoppelt ist und die Verbindung zum Leitungssystem PBUS der Prozessoreinheit PROC herstellt.

Der Steuerteil der Prozessoreinheit PROC besteht aus einer in üblicher Weise aufgebauten Mikroprozessorsteuerung µ-CTL mit Mikroprogrammspeicher CM und Befehlsregister MIR. Letzteres liefert in an sich bekannter Weise die den Steuerungsablauf bestimmenden Steuerbefehle und Signale CODE/SUBF, die von der Steuerung µ-CTL in Schaltsignale SIG umgesetzt werden, sowie Adressen BR-AD bzw. AD für Verzweigungen bzw. Speicherzugriffe.

Die jeweilige Mikrobefehlsadresse CM-AD für die Ansteuerung des Mikrobefehlsspeichers CM wird im Register MIAL bereitgestellt, das über einen vorgeschalteten Auswahlschalter MIAM aus einer von mehreren Quellen geladen werden kann. Normalerweise bildet das die durch einen Inkrementer INC ermittelte lineare Folgeadresse aufnehmende Register INCR die Quelle. In einem mit dem Ausgang dieses Registers gekoppelten Register PR kann die lineare Folgeadresse zwischengespeichert und damit nach einem Programmaussprung als Rücksprungadresse für die Fortsetzung des unterbrochenen Programms zur Verfügung gestellt werden.

Das Register PR steht symbolisch für einen Kellerspeicher mit Steuerung, um bei mehreren aufeinanderfolgenden Unterprogrammsprüngen die entsprechenden Rücksprungadressen zu sichern. Durch das Register JINDR kann weiterhin auf eine indirekt vorgegebene Programmadresse umgesteuert werden, während mit einer Verzweigungsadresse BR-AD aus dem Mikrobefehlsregister MIR in vorbestimmter Weise eine Programmverzweigung eingeleitet werden kann.

Der Ausgang des Registers MIAL ist außerdem mit einem weiteren Register TR für die Zwischenspeicherung einer bereitgestellten Mikroprogrammadresse CM-AD verbunden, um sie für die Adressenrechnung durch den Verarbeitungsteil oder für eine Befehlswiederholung verfügbar zu haben.

In Auswirkung der Erfindung ist die Mikroprogrammsteuerung µ-CTL mit einer gesonderten Steuereinheit STE gekoppelt, die mit fest verdrahteter Logik arbeitet und durch eine Subfunktion CM-LD der Mikrobefehle wirksam schaltbar ist.

Der Verarbeitungsteil der Prozessoreinheit PROC besteht in an sich bekannter Weise aus einer arithmetisch/logischen Verknüpfungseinheit ALU mit vorgeschalteten Operandenregistern AL und BL und einem Ergebnisregister ACU. Den Operandenregistern vorgeschaltete Auswahlschalter AWSA bzw. AWSB ermöglichen die Bereitstellung der jeweils benötigten Operanden aus verschiedenen Quellen. Neben dem Ergebnisregister ACU sind dies beispielsweise zwei Registersätze FMR und INTR, wobei auch die Inhalte aus den Registern JINDR, PR und TR der Mikroprogrammadreßsteuerung über einen weiteren Auswahlschalter AWSI als Operanden auswählbar sind.

Steuerungsteil und Verarbeitungsteil der Prozessoreinheit PROC sind über ein internes Leitungssystem IBUS gekoppelt, das vom Leitungssystem PBUS aus über einen Auswahlschalter AWS1 ansteuerbar ist, über den auch der Ausgang der arithmetisch/logischen Verknüpfungseinheit ALU auf das interne Leitungssystem IBUS schaltbar ist, während an das Leitungssystem PBUS vom Verarbeitungsteil abzugebende Daten beispielsweise vom Operandenregister AL geliefert werden. Über das interne Leitungssystem IBUS sind desweiteren die Register ACU, FMR, INTR und JINDR sowie das Laderegister LR für den Mikroprogrammspeicher CM mit Daten ladbar. An das Leitungssystem PBUS kann gegebenenfalls noch ein lokaler Speicher LS angeschlossen sein, dessen Adressenregister LADR ebenfalls vom internen Leitungssystem IBUS aus ladbar ist.

Die Eintrage im Mikroprogrammspeicher werden gemäß der Erfindung nur durch Paritätsbits gesichert, was durch die mit dem Befehlsregister MIR gekoppelte Paritätsprüfeinrichtung PC überwacht wird, wenn ein Eintrag gelesen und ins Befehlsregister MIR übernommen wird. Dabei ermittelte Paritätsfehler werden der Steuerung µ-CTL mit dem Signal CMPE angezeigt.

Außerdem sind für den Austausch von fehlerhaft arbeitenden Speicherbausteinen des Mikroprogrammspeichers CM Ersatzbausteine EB vorgesehen. Die Umsteuerung auf diese Ersatzbausteine EB wird in an sich bekannter Weise am Eingang zum Mikroprogrammspeicher CM durch ein Eingaberekonfigurationsnetzwerk IRN und am Ausgang durch ein Ausgaberekonfigurationsnetzwerk ORN abhängig von den in den zugehörigen Rekonfigurationsregistern ISR bzw. OSR enthaltenen Werten vorgenommen. Diese Werte werden in bekannter Weise abhängig vom jeweils als fehlerhaft ermittelten Speicherbaustein beispielsweise vom Serviceprozessor SVP der Datenverarbeitungsanlage ermittelt und dann von diesem in die Register geladen.

Der Serviceprozessor ist in Figur 1 nur angedeutet. Er steht mit der Prozessoreinheit PROC über eine gesonderte Serviceschnittstelle SI in Verbindung, was z.B. in der deutschen Patentschrift 28 42 603 näher erläutert ist. In gleicher Weise sind z.B. auch die Register LR, MIR, MIAL, JINDR und TR vom Serviceprozessor SVP ansteuerbar, was jeweils durch den gleichnamigen Steuereingang gekennzeichnet ist, so daß Daten abgerufen oder geladen werden können. So können im Stoppzustand durch Laden des Registers MIAL mit einer Speicheradresse CM-AD und des Registers LR mit einem Mikrobefehl Befehle bei direkter Steuerung durch den Serviceprozessor SVP in den Mikroprogrammspeicher CM geschrieben und auch gelesen werden.

Daneben ist auch ein durch Befehle des Mikroprogrammspeichers CM gesteuertes Laden des Mikroprogrammspeichers mit Mikrobefehlen aus dem Arbeitsspeicher MM anhand von vom Verarbeitungsteil berechneten Speicheradressen möglich. Dies dient dazu, um nach Lesen eines fehlerbehafteten Mikrobefehls aus dem Mikroprogrammspeicher CM abhängig von der Fehlersignalisierung CMPE diesen Befehl aus dem Arbeitsspeicher MM nachladen oder um nach erfolgter Umschaltung auf die Ersatzbausteine EB den Mikroprogrammspeicher CM neu laden zu können.

Weiterhin ist, gesteuert durch die gesonderte Steuereinheit STE, vorgesehen, daß nach jedem Schreibvorgang für den Mikroprogrammspeicher der eingeschriebene Mikrobefehl wieder gelesen und durch die Paritätsprüfeinrichtung PC überprüft wird, um sicherzugehen, daß der eingeschriebene Befehl auch fehlerfrei ist. Bei dieser Leseprüfung werden die Ausgänge des Befehlsregisters MIR mit dem Signal INH unwirksam geschaltet, so daß der gelesene Befehl ohne Auswirkung auf die Mikroprogrammsteuerung bleibt.

Dieser Prüfmechanismus wird auch für die serielle Überprüfung der Einträge im Mikroprogrammspeicher verwendet, wenn sich die Mikroprogrammsteuerung im Leerlaufzustand befindet, wobei der Schreibvorgang entfällt.

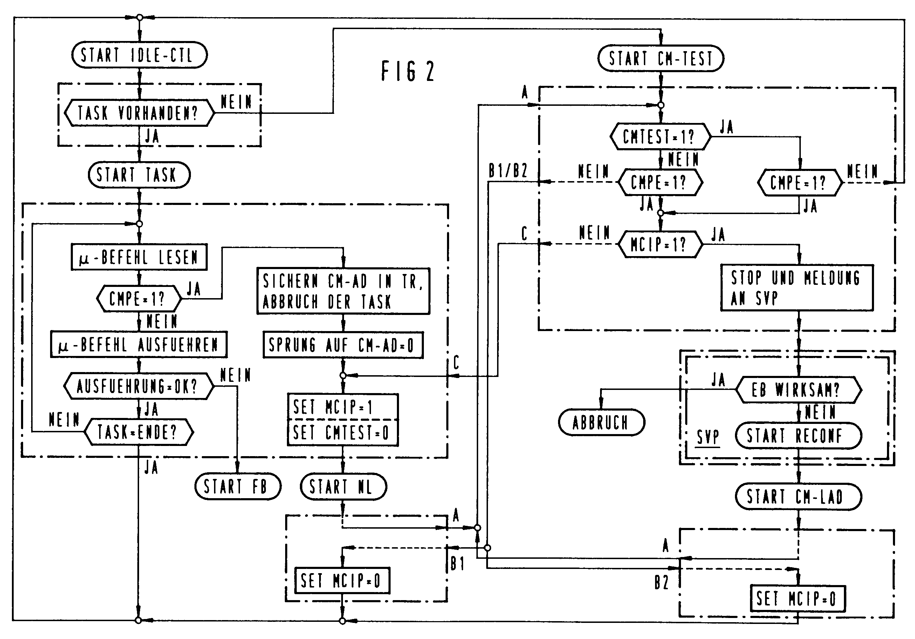

Figur 2 zeigt in Form eines Ablaufdiagrammes eine schematische Übersicht des sich danach ergebenden Steuerungsablaufes für die Mikroprogrammsteuerung der Prozessoreinheit PROC von Figur 1. Ausgangspunkt ist mit "START IDLE-CTL" die Überprüfung auf den Leerlaufzustand. Stehen keine Verarbeitungsaufgaben "TASK" an, wird mit "START CM-TEST" in die Prüfroutine für den Mikroprogrammspeicher CM übergeleitet, was durch einen dabei gesetzten Testmerker CMTEST gekennzeichnet wird. Ergibt die Überprüfung gemäß CMPE≠1 einen fehlerfrei gelesenen Mikrobefehl, so wird mit "START IDLE-CTL" auf die Leerlaufüberwachung zurückgesprungen und bei Fortbestehen des Leerlaufzustandes die Prüfroutine für den nächstfolgenden Befehl erneut eingeleitet.

Wird im Rahmen dieser Prüfungen gemäß CMPE=1 ein fehlerbehafteter Befehl gelesen, wird geprüft, ob bereits der Merker MCIP gesetzt ist und damit anzeigt, ob es sich bei dem überprüften Befehl um einen infolge eines vorhergehenden Fehlers bereits im Rahmen der Fehlerbehandlung aus dem Arbeitsspeicher MM nachgeladenen Befehl handelt. Ist der Merker MCIP noch nicht gesetzt, wird nach seinem Setzen mit "START NL" die Nachladeroutine angestoßen, in deren Verlauf nach Abschluß des Nachladevorganges über den Verzweigungsweg A auf die Testroutine übergeleitet und der nachgeladene Befehl überprüft wird. Da in diesem Falle der Testmerker CMTEST nicht mehr gesetzt ist, wird bei fehlerfrei gelesenem Befehl gemäß CMPE≠1 über den Verzweigungsweg B1 in die Nachladeroutine zurückgesprungen und diese beendet.

Wird bei der Überprüfung des nachgeladenen Befehls wiederum ein Fehler festgestellt, dann erfolgt wegen MCIP=1 ein Maschinenstopp mit entsprechender Meldung an den Serviceprozessor SVP. Sollten die Ersatzbausteine EB des Mikroprogrammspeichers CM noch nicht wirksam geschaltet sein, wird das Ersatzschalteprogramm ausgeführt und anschließend die Steuerung für das Neuladen des Mikroprogrammspeichers wieder an die Mikroprogrammsteuerung übergeben.

Mit jedem aus dem Arbeitsspeicher MM bereitgestellten Mikrobefehl wird dann wie bei der zuvor angesprochenen Nachladeroutine NL über den Verzweigungsweg A in die Prüfroutine übergeleitet und der neu eingeschriebene Befehl überprüft. Ist er fehlerfrei, wird über den Verzweigungsweg B2 in die Neuladeroutine CM-LAD zurückgesprungen und das Nachladen des nächsten Befehls veranlaßt, bis der gesamte Mikroprogrammspeicher CM neu geladen ist und damit wieder auf die Leerlaufüberwachung übergegangen werden kann.

Tritt nach erfolgter Ersatzschaltung für den Mikroprogrammspeicher CM nochmals ein zum Maschinenstopp führender Fehler auf, dann wird das laufende Fehlerbeseitigungsprogramm abgebrochen, da im Steuerungsablauf alle vorgesehenen Fehlerbeseitigungsmöglichkeiten ausgeschöpft sind. Die weitere Fehlerbeseitigung obliegt nunmehr dem Servicedienst.

Wird im Rahmen der Leerlaufüberwachung festgestellt, daß die Mikroprogrammsteuerung zur Erledigung einer anstehenden Aufgabe "TASK" benötigt wird, dann wird diese mit "START TASK" für die Bearbeitung freigegeben, wobei nacheinander ein Mikrobefehl gelesen, auf Fehlerfreiheit überprüft und ausgeführt wird. Verläuft die Befehlsausführung ebenfalls fehlerfrei, wird, falls nicht das Ende des Auftrages erreicht ist, der nächste Befehl gelesen usw., bis am Ende wieder auf die Leerlaufkontrolle übergeleitet wird.

Wird dagegen bei einem gelesenen Befehl gemäß CMPE=1 ein Fehler festgestellt, dann wird die zugehörige Mikroprogrammspeicheradresse CM-AD für den späteren Programmrücksprung gesichert und nach Setzen des Merkers MCIP in die bereits angesprochene Nachladeroutine NL übergeleitet.

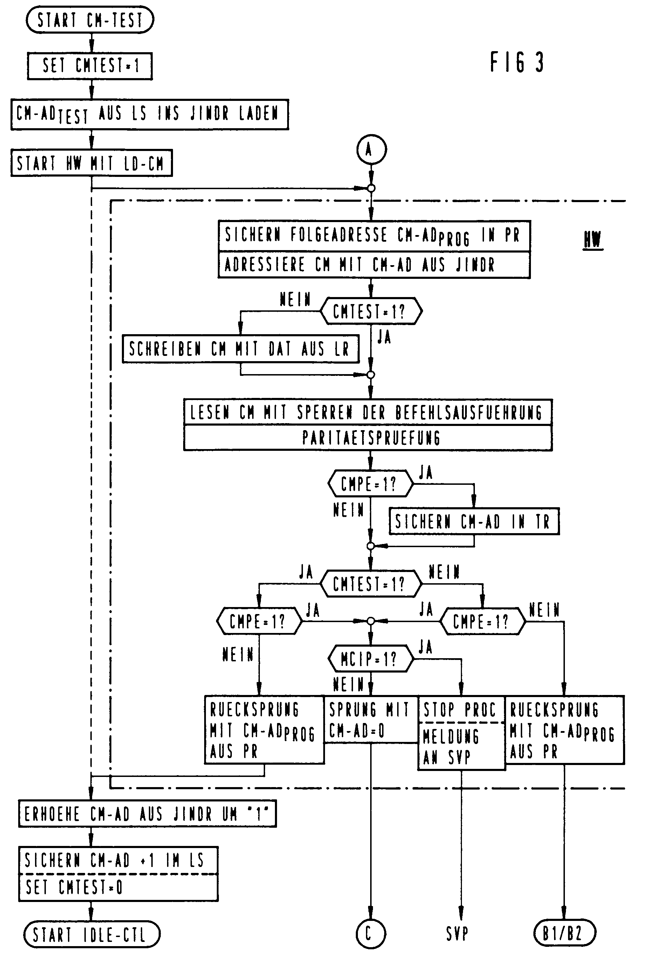

Figur 3 zeigt nähere Einzelheiten des Steuerungsablaufes während der mit "START CM-TEST" eingeleiteten Prüfroutine. Zu Beginn wird der in Verbindung mit Figur 2 bereits angesprochene Testmerker CMTEST gesetzt und die Testadresse CM-AD_{TEST} aus dem lokalen Speicher LS ins Register JINDR geladen.

Der weitere Steuerungsablauf wird durch die Subfunktion LD-CM im steuernden Mikrobefehl ausgelöst. Er erfolgt rein hardware gesteuert durch die Steuereinheit STE, was innerhalb der strichpunktierten Umrandung mit HW angedeutet ist. Durch diese Überleitung auf die Hardwaresteuerung kann jeder im Mikroprogrammspeicher CM eingetragene Mikrobefehl auf dem normalerweise vorgegebenen funktionellen Verarbeitungsweg, CM-MIR überprüft werden, wenn dabei die Auswirkung des jeweils ins Befehlsregister MIR übernommenen Mikrobefehls auf die Steuerung µ-CTL unterdrückt wird, was in einfacher Weise durch Sperrung der Ausgänge des Befehlsregisters MIR erfolgen kann und was in Figur 1 durch das Steuersignal INH bewirkt wird.

Damit nach dem Übergang auf die Hardwaresteuerung eine Rückkehr in das jeweilige Mikroprogramm und dessen Fortsetzung möglich ist, wird als erstes die Folgeadresse CM-AD_{PROG} des steuernden Programms wie bei einem Sprung in ein Unterprogramm im Register PR gesichert. Anschließend wird mit der im Register JINDR bereitgestellten Adresse der Mikroprogrammspeicher CM adressiert und, da beim Lauf der Prüfroutine der Testmerker CMTEST gesetzt ist, der adressierte Befehl gelesen und von der Paritätsprüfeinrichtung überprüft. Abhängig vom Setzzustand der Merker CMTEST und MCIP sowie vom jeweiligen Prüfergebnis CMPE wird dann, wie anhand von Figur 2 bereits erläutert, die Entscheidung über die Fortsetzung des Steuerungsablaufes getroffen.

Ist der gelesene Befehl gemäß CMPE≠1 fehlerfrei und liegt gemäß CMTEST=1 ein Prüflauf vor, dann wird mit der im Register PR hinterlegten Adresse in das unterbrochene Mikroprogramm der Prüfroutine zurückgesprungen und diese fortgesetzt, indem zunächst die Testadresse CM-AD_{TEST} im Register JINDR durch den Verarbeitungsteil um den Wert 1 erhöht und die dadurch erhaltene Folgeadresse für den nächsten zu überprüfenden Befehl im lokalen Speicher LS abgelegt. Danach wird mit SET CMTEST=0 das Ende der Prüfroutine angezeigt und auf die Leerlaufüberprüfung IDLE-CTL übergeleitet.

Wurde dagegen bei dem gelesenen Befehl gemäß CMPE=1 ein Paritätsfehler festgestellt, dann wird die zugehörige Adresse im Register TR gesichert und, falls der Fehler entsprechend MCIP ≠1 zum ersten Mal aufgetreten ist, hartgesteuert auf die mikroprogrammgesteuerte Fehlerbehandlung übergegangen, beispielsweise anhand der fest eingestellten Mikroprogrammadresse CM-AD=0. Mit dem dadurch enthaltenen Befehl wird entsprechend dem Verzweigungsweg C von Figur 2 der Merker MCIP gesetzt und mit "START NL" auf die Nachladeroutine übergeleitet.

Wie im Zusammenhang mit Figur 2 bereits erläutert, wird der Prüfmechanismus der Prüfroutine CM-TEST auch beim Nachladen eines Befehls und beim vollständigen Neuladen des Mikroprogrammspeichers CM über den Verzweigungsweg A angesteuert. Genutzt wird dabei allein die Hardwaresteuerung durch die Steuereinheit STE. In diesem Falle ist der Testmerker CMTEST zurückgesetzt, so daß dem Lesen immer erst ein Schreiben des bereitgestellten nachzuladenden Mikrobefehls vorausgeht. Ist der gelesene Befehl fehlerfrei, erfolgt wie bei der Prüfroutine ein Rücksprung anhand der im Register PR gesicherten Folgebefehlsadresse CM-AD_{PROG} des unterbrochenen Mikroprogramms entsprechend dem Verzweigungsweg B1 bzw. B2. Bei erneutem Fehler wird dagegen wegen MCIP=1 mit STOP PROC ein Maschinenstopp ausgelöst und eine Meldung an den Serviceprozessor SVP abgegeben, der dann die weitere Steuerung übernimmt.

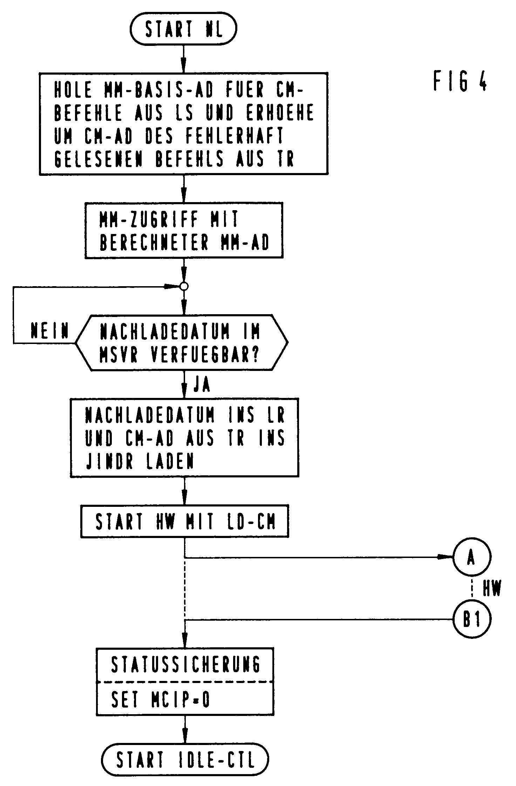

Der Steuerungsablauf der Nachladeroutine NL ergibt sich aus Figur 4. Als erstes wird aus dem lokalen Speicher LS die Basisadresse für die Mikrobefehle im Mikroprogrammspeicher CM an den Verarbeitungsteil übergeben und um die im Register TR gesicherte Adresse CM-AD des fehlerbehaftet gelesenen Befehls erhöht. Mit der so berechneten Speicheradresse MM-AD erfolgt dann der Zugriff zum Hauptspeicher MM. Ist das Nachladedatum in der Schnittstellensteuerung MSVR verfügbar, wird es ins Laderegister LR für den Mikroprogrammspeicher CM übertragen und das Register JINDR mit der Befehlsadresse aus dem Register TR geladen. Mit der Subfunktion LD-CM wird dann entsprechend dem Verzweigungsweg A auf die Hardwaresteuerung der Prüfroutine übergeleitet und der Mikroprogrammlauf unterbrochen.

War das Nachladen erfolgreich, dann erfolgt entsprechend dem Verzweigungsweg B1 ein Rücksprung in die unterbrochene Nachladeroutine, die im Rahmen der laufenden Fehlerbehandlung mit der Statussicherung fortgesetzt wird. Danach wird der Merker MCIP wieder zurückgesetzt und als letztes der Fehlerbehandlung auf die Leerlaufüberwachung übergeleitet.

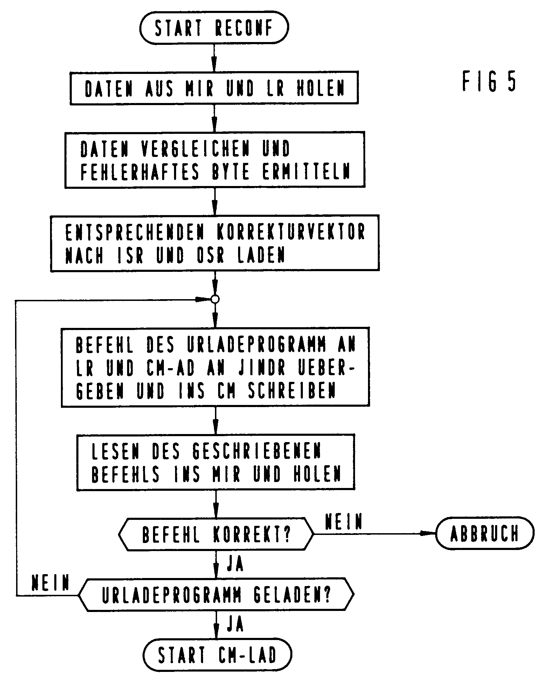

Figur 5 zeigt den durch den Serviceprozessor SVP gesteuerten Ablauf des Ersatzschalteprogramms, das gemäß Figur 2 aufgerufen wird, wenn die Ersatzbausteine EB für den Mikroprogrammspeicher CM noch nicht wirksam geschaltet sind. Danach werden zunächst die Befehle aus dem Laderegister LR und dem Befehlsregister MIR, die übereinstimmen sollten vom Serviceprozessor abgeholt, die Daten miteinander verglichen und das fehlerhafte Byte ermittelt. Die entsprechenden Korrekturvektoren für die Einstellung der Rekonfigurationsnetzwerke IRN und ORN werden anschließend in die Rekonfigurationsregister ISR und OSR geladen, die die Umschaltung auf die Ersatzbausteine bewirken. Danach werden die Befehle für das Urladeprogramm nacheinander vom Serviceprozessor SVP aus in den Mikroprogrammspeicher CM geladen, indem der jeweilige Befehl ins Laderegister LR und die zugehörige Adresse CM-AD ins Register JINDR übertragen werden und anschließend ein Schreibimpuls ausgelöst wird. Mit einem nachfolgenden Leseimpuls wird der jeweils eingeschriebene Befehl ins Befehlsregister MIR übernommen und von dort zum Serviceprozessor SVP zur Überprüfung auf Korrektheit übertragen. Ist der Befehl fehlerfrei, wird der nächste Befehl in den Mikroprogrammspeicher CM geladen, bis schließlich das gesamte Urladeprogramm im Mikroprogrammspeicher verfügbar ist. Zum Abschluß wird mit Aufruf des Neuladeprogramms die Steuerung wieder an die Mikroprogrammsteuerung der Prozessoreinheit PROC übergeben.

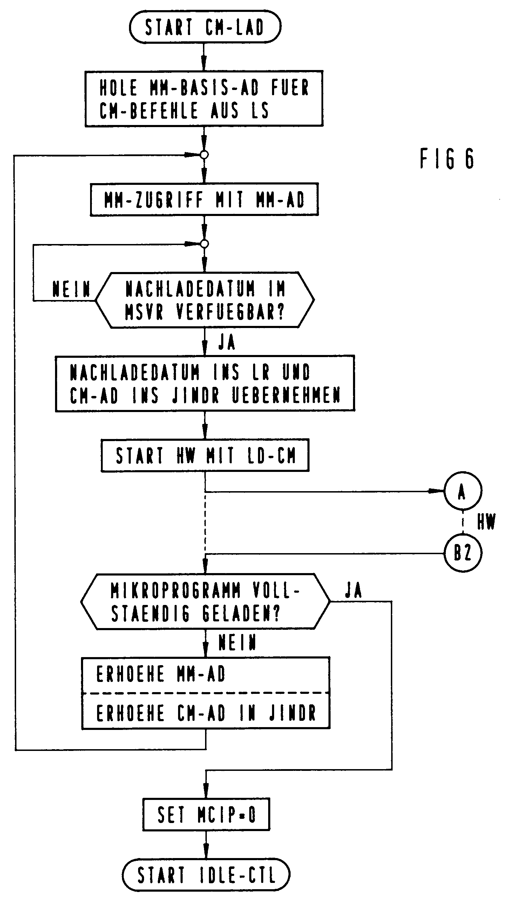

Mit "START CM-LAD" wird nun das zuvor geladene Urladeprogramm ausgeführt, dessen Steuerungsablauf in Figur 6 wiedergegeben ist. Begonnen wird dabei mit dem Holen der Basisadresse aus dem lokalen Speicher LS für den Zugriff auf die Mikrobefehle im Hauptspeicher MM und der Durchführung des Zugriffes. Ist das Nachladedatum in der Schnittstellensteuerung MSVR verfügbar, dann wird es ins Laderegister LR übernommen und das Register JINDR mit der zugehörigen Adresse CM-AD geladen. Damit sind wiederum die Voraussetzungen für die Überleitung auf den Prüfmechanismus der Prüfroutine von Figur 3 durch die Subfunktion LD-CM erfüllt.

Ist der überprüfte Befehl fehlerfrei wird entsprechend dem Verzweigungsweg B2 in das unterbrochene Neuladeprogramm zurückgesprungen und dieses fortgesetzt. Als erstes wird dabei geprüft, ob alle Befehle geladen sind. Solange dies nicht der Fall ist, wird durch den Verarbeitungsteil die vorangegangene Speicheradresse MM-AD und die Mikrobefehlsadresse im Register JINDR jeweils um eins erhöht und der Arbeitsspeicherzugriff wiederholt, bis schließlich das gesamte Mikroprogramm in den Mikroprogrammspeicher CM neu geladen ist. Zum Abschluß wird der Merker MCIP wieder zurückgesetzt und auf die Leerlaufüberwachung IDLE-CTL umgesteuert.

## Patentansprüche

1. Verfahren zur Erhöhung der Fehlerfreiheit von in Mikroprogrammspeichern (CM) von Prozessoreinheiten (PROC) einer Datenverarbeitungsanlage gespeicherten Mikrobefehlen,
**gekennzeichnet** durch die Kombination folgender Maßnahmen:
1.Abschnittsweise Sicherung der einzelnen Mikrobefehle durch ein Paritätsbit je Abschnitt.
2.Ständige Überwachung der Mikrobefehlssteuerung auf Vorliegen des Leerlaufzustandes und des Arbeitszustandes.
3.Sequentiell umlaufendes, mikroprogrammgesteuertes Adressieren und Lesen der Mikrobefehle im Mikrobefehlsspeicher (CM) und Übernahme ins Befehlsregister (MIR) mit Sperrung der Befehlsausführung in den Zeiten des Leerlaufzustandes.
4.Überprüfung eines jeden ins Mikrobefehlsregister (MIR) übernommenen Befehls anhand der Paritätsbits und Einleitung einer Fehlerbehandlung im Fehlerfall (CMPE=1) mit Sperrung einer im Arbeitszustand bereits eingeleiteten Befehlsausführung.
5.Die eingeleitete Fehlerbehandlung umfaßt:
a)Mikroprogrammgesteuertes Nachladen eines als fehlerhaft erkannten Mikrobefehls aus dem Arbeitsspeicher (MM) der Datenverarbeitungsanlage mit anschließendem Lesen und Prüfen des nachgeladenen Mikrobefehls.
b)Bei einem fehlerhaft gelesenen nachgeladenen Mikrobefehl: Fortsetzung der Fehlerbehandlung mit Umsteuerung der Schreib- und Lesepfade des Mikroprogrammspeichers (CM) von der fehlerhaften Speicherabschnittsspalte auf einen Ersatzspeicher (EB) durch den Serviceprozessor (SVP) und Neuladen des gesamten Mikroprogrammspeichers (CM) aus dem Arbeitsspeicher (MM) der Datenverarbeitungsanlage mit anschließendem Lesen und Prüfen des jeweils nachgeladenen Mikrobefehls oder Prozessorstopp und Abbruch der Fehlerbehandlung, wenn der Ersatzspeicher (EB) vor dem Nachladen des Mikrobefehls bereits wirksam geschaltet war.
c)Bei einem fehlerfrei gelesenen nachgeladenen Mikrobefehl: Rücksprung ins jeweils unterbrochene Programm (CM-Test, NL, CM-LAD).

2. Verfahren nach Anspruch 1,
**dadurch gekennzeichnet,**
daß das Lesen eines im Leerlaufzustand der Prozessoreinheit (PROC) zu prüfenden Mikrobefehls des Mikroprogrammspeichers (CM) durch eine Subfunktion (LD-CM) im steuernden Mikrobefehl der zuständigen Prüfroutine (CM-TEST) eingeleitet wird, die ähnlich einem Unterprogrammsprung in einen durch eine gesonderte Steuereinheit (STE) gesteuerten Hardwaresteuerungsablauf mit Sicherung der Rücksprungadresse für das unterbrochene Mikroprogramm überleitet, und daß während dieses Hardwaresteuerungsablaufes folgende Steuerfunktionen ausgeführt werden:
- Adressierung des zu prüfenden Mikrobefehls im Mikroprogrammspeicher CM,
- Lesen des adressierten Mikrobefehls und Übernahme in das Befehlsregister (MIR) bei gleichzeitiger Sperrung der Registerausgänge,
- Durchführung der Paritätsprüfung und
- Sprung ins weiterführende Mikroprogramm.

3. Verfahren nach Anspruch 2,
**dadurch gekennzeichnet,**
daß der Hardwaresteuerungsablauf analog den Maschinenzyklen der Mikroprogrammsteuerung durch Taktimpulse gesteuert wird und die einzelnen Steuerfunktionen in aufeinanderfolgenden Zyklen ausgeführt werden.

4. Verfahren nach Anspruch 2 oder 3,
**dadurch gekennzeichnet,**
daß der Hardwaresteuerungsablauf in gleicher Weise im Rahmen der Nachladeroutine (NL) für einen fehlerbehaftet gelesenen Mikrobefehl und im Rahmen der Neuladeroutine (CM-LAD) für den Mikrobefehlsspeicher (CM) nach Wirksamschalten des Ersatzspeichers (EB) zur Überprüfung eines jeden vom Arbeitsspeicher (MM) bereitgestellten und zu ladenden Mikrobefehls wirksam geschaltet wird, wobei vor dem Lesevorgang ein Schreibvorgang für den bereitgestellten Mikrobefehl ausgeführt wird.

5. Verfahren nach Anspruch 4,
**dadurch gekennzeichnet,**
daß das Einfügen des Schreibvorganges in den Hardwaresteuerungsablauf abhängig vom Setzzustand eines Testmerkers (CMTEST) gesteuert wird, der lediglich bei Einleitung der Prüfroutine (CM-TEST) im Leerlaufzustand gesetzt und nach Auftreten eines Paritätsfehlers (CMPE=1) bei einem gelesenen Mikrobefehl zurückgesetzt wird.

6. Verfahren nach Anspruch 4 oder 5,
**dadurch gekennzeichnet,**
daß der Aussprung aus dem Hardwaresteuerungsablauf bei einem während des Hardwaresteuerungsablaufes festgestellten Paritätsfehler (CMPE=1) abhängig vom Setzzustand eines gesonderten Merkers (MCIP) in der Weise gesteuert wird, daß bei nichtgesetztem gesondertem Merker (MCIP≠1) auf die Nachladeroutine (NL) übergeleitet und bei gesetztem gesondertem Merker (MCIP=1) die Steuerung an den Serviceprozessor (SVP) abgegeben wird, und daß der gesonderte Merker (MCIP) jeweils unmittelbar vor Einleitung der Nachladeroutine (NL) gesetzt und jeweils nach erfolgreicher Fehlerbehandlung wieder zurückgesetzt wird.

7. Verfahren nach einem der Ansprüche 1 bis 6,
**dadurch gekennzeichnet,**
daß die Überwachung des Leerlaufzustandes durch eine Leerlaufüberwachungsroutine (IDLE-CTL) erfolgt, die nach jedem beendeten Aufgabenprogramm (TASK) aufgerufen wird und bei Feststellung des Leerlaufzustandes die Prüfroutine (CM-TEST) aufruft, daß von der Prüfroutine (CM-TEST) jeweils nur einer der Mikrobefehle im Mikroprogrammspeicher (CM) überprüft wird und daß sowohl nach positiv verlaufender Prüfung im Rahmen der Prüfroutine (CM-TEST) als auch nach jeder erfolgreichen Fehlerbehandlung durch die Nachladeroutine (NL) oder gegebenenfalls durch das Neuladen (CM-LAD) nach Rekonfiguration (RECONF) des Mikroprogrammspeichers (CM) die Steuerung wieder an die Leerlaufüberwachungsroutine (IDLE-CTL) übergeben wird.

8. Mikroprogrammsteuerung zur Durchführung des Verfahrens nach einem der Ansprüche 1 bis 7,
**dadurch gekennzeichnet,**
daß sie eine gesonderte Steuereinheit (STE) aufweist, die durch eine in den Mikroprogrammbefehlen enthaltende Subfunktion (CM-LD) jeweils wirksam schaltbar ist und Schalteinrichtungen zur Durchführung folgender aufeinanderfolgender Steuerfunktionen aufweist:
a)zur Sicherung der Adresse (CM-AD) des das Wirksamschalten der Steuereinheit (STE) auslösenden Mikrobefehls,
b)zur Adressierung des Mikroprogrammspeichers (CM) anhand der vom Mikroprogramm vorher bereitgestellten Adresse (CM-AD),
c)zum Lesen des adressierten Mikroprogrammspeichers (CM),
d)zur Übernahme des gelesenen Mikrobefehls ins Befehlsregister (MIR) und Sperrung der Registerausgänge zur Verhinderung der Befehlsausführung,
e)zur Auswertung des Ergebnisses der Paritätsprüfung für den gelesenen Mikrobefehl,
f)zur Entscheidung über die Fortsetzung des weiteren Mikroprogrammlaufes und
g)zur Durchführung des entsprechenden Rücksprunges in den Mikroprogrammlauf.

9. Mikroprogrammsteuerung nach Anspruch 8,
**dadurch gekennzeichnet,**
daß die Steuereinheit (STE) weitere Schalteinrichtungen zur Durchführung folgender zusätzlicher Steuerfunktionen aufweist:
a) zur Auswertung eines Testmerkers (CMTEST) und
b) zum Schreiben eines im Laderegister (LR) durch das Mikroprogramm vorher bereitgestellten Mikrobefehls in den Mikroprogrammspeicher (CM) vor dem jeweiligen Lesen des adressierten Mikroprogrammspeichers abhängig vom Setzzustand des Testmerkers (CMTEST).

10. Mikroprogrammsteuerung nach Anspruch 9,
**dadurch gekennzeichnet,**
daß die Steuereinheit (STE) weitere Schalteinrichtungen zur Auswertung eines gesonderten Merkers (MCIP) aufweist und daß die Schalteinrichtungen zur Entscheidung über die Fortsetzung des weiteren Mikroprogrammlaufes bei einem vorgegebenen Setzzustand (MCIP=1) des gesonderten Merkers statt des Rücksprunges in den Mikroprogrammlauf einen Maschinenstopp mit Aufruf des Serviceprozessors (SVP) veranlaßt.
